# EUROPEAN PATENT SPECIFICATION

(11) **EP 2 353 018 B1**
(45) Date of publication and mention of the grant of the patent: **23.01.2013**
(21) Application number: 09745123.1
(22) Date of filing: 21.10.2009
(51) Int. Cl.: G01R 31/317

(54) **INTEGRATED CIRCUIT AND TEST METHOD THEREFOR**
INTEGRIERTE SCHALTUNG UND TESTVERFAHREN DAFÜR
CIRCUIT INTÉGRÉ ET PROCÉDÉ DE TEST CORRESPONDANT

(30) Priority: 31.10.2008 EP 08105715
(43) Date of publication of application: 10.08.2011
(73) Proprietor: NXP B.V., 5656 AG Eindhoven (NL)
(72) Inventor: DHAYNI, Achraf, NL-5656 AE Eindhoven (NL)
(74) Representative: Williamson, Paul Lewis
(86) International application number: PCT/IB2009/054642
(87) International publication number: WO 2010/049853

(56) References cited:
- BHATTACHARYA S ET AL: "A Built-In Loopback Test Methodology for RF Transceiver Circuits Using Embedded Sensor Circuits" TEST SYMPOSIUM, 2004. 13TH ASIAN KENTING, TAIWAN 15-17 NOV. 2004, PISCATAWAY, NJ, USA,IEEE, 15 November 2004 (2004-11-15), pages 68-73, XP010757148 ISBN: 978-0-7695-2235-7
- EISENSTADT W R ET AL: "Embedded Loopback Test for RF ICs" IEEE TRANSACTIONS ON INSTRUMENTATION AND MEASUREMENT, IEEE SERVICE CENTER, PISCATAWAY, NJ, US, vol. 54, no. 5, 1 October 2005 (2005-10-01), pages 1715-1720, XP011140019 ISSN: 0018-9456
- NEGREIROS M ET AL: "Low cost analog testing of RF signal paths" DESIGN, AUTOMATION AND TEST IN EUROPE CONFERENCE AND EXHIBITION, 2004. PROCEEDINGS FEB. 16-20, 2004, PISCATAWAY, NJ, USA,IEEE, vol. 1, 16 February 2004 (2004-02-16), pages 292-297, XP010684587 ISBN: 978-0-7695-2085-8 cited in the application
- DONGHOON HAN ET AL: "On-Chip Self-Calibration of RF Circuits Using Specification-Driven Built-In Self Test (S-BIST)" ON-LINE TESTING SYMPOSIUM, 2005. IOLTS 2005. 11TH IEEE INTERNATIONAL SAINT RAPHAEL, FRENCH RIVIERA, FRANCE 06-08 JULY 2005, PISCATAWAY, NJ, USA,IEEE, 6 July 2005 (2005-07-06), pages 106-111, XP010831267 ISBN: 978-0-7695-2406-1

## Description

### FIELD OF THE INVENTION

The present invention relates to a method of testing an integrated circuit comprising a radio-frequency (RF) transceiver, said transceiver comprising a receiver chain having an input for coupling the receiver chain to an antenna and an output coupled to the digital signal processor, and a transmitter chain having an input coupled to the digital signal processor and an output for each arranged to be coupling the transmitter chain to an antenna; and a RF calibration signal generator for generating a RF calibration signal.

The present invention further relates to such an integrated circuit (IC).

### BACKGROUND OF THE INVENTION

Developments in semiconductor manufacturing have enabled the production of highly complex ICs both in terms of feature density and functionality. Consequently, the cost of testing such ICs now dominates the overall manufacturing cost of complex ICs, because it is far from trivial to test such devices, such that many different tests may be required to achieve an acceptable level of fault coverage, which can make the whole test process extremely time-consuming, not in the least because large amounts of test data have to be communicated over relatively slow connections between the device under test (DUT) and external automated test equipment (ATE).

This has led to the development of so-called built-in self test (BIST) solutions, which are essentially test engines that are embedded in the IC such that the amount of data that needs communicating between the DUT and the ATE can be significantly reduced. In extreme cases, this data communication can be reduced to two signals; the provision of a test enable signal for initiating the BIST and the collection of a single bit indicating the DUT passing or failing the BIST. Hence, the overall test time is significantly reduced because virtually all test data is communicated over connections within the DUT, which are much quicker than the connections between the ATE and the DUT. BIST solutions are particularly applicable in the digital IC domain because the test stimuli are bit patterns that can be easily generated by a pattern generator.

However, analogue BIST solutions cannot be provided that easily because the accuracy of an analogue test result is directly linked to the signal quality of the test signal. For this reason, analogue BIST solutions usually impose a significant area overhead penalty on the IC design.

Yet, there is a desire for providing such BIST solutions, in particular in the field of mobile communication, where ICs typically comprise a transceiver stage for processing RF signals. Conventional ATEs are incapable of generating good-quality RF test signals such that an IC manufacturer is faced with having to invest a substantial amount of money into the manufacturing process to provide dedicated testers for ICs that process RF signals. This has triggered a considerable effort in this field to come up with BIST solutions that avoid having to make these investments.

An example of such a BIST solution is proposed in "Low Cost Analog Testing of RF Signal Paths" by M. Negreiros et al. in Proceedings of the Design, Automation and Test in Europe Conference and Exhibition, 2004, Volume 1, pages 292-297. In this proposed solution, a noise generator is coupled to a digital signal processor by a data bus, with several transceiver nodes being coupled to the data bus via respective statistical samplers. The statistical samplers produce digital outputs such that an analogue transceiver signal can immediately be processed by the digital signal processor. A drawback of this solution is that it adds a significant amount of test-dedicated hardware to the IC. Moreover, this paper merely emulates the proposed test principle using off-chip components such that it is questionable whether the proposed solution actually works when integrated as a BIST solution.

### SUMMARY OF THE INVENTION

The present invention seeks to provide a more area-efficient built-in self test method for an IC comprising a RF transceiver.

The present invention further seeks to provide an IC comprising a RF transceiver and a more area-efficient built-in self test arrangement.

According to a first aspect of the invention, there is provided a method of testing an integrated circuit as disclosed in claim 1.

This method of based on the realization that many RF ICs comprise an on-chip RF signal source for calibration purposes, such as a phase-locked loop (PLL) operable in the RF range. Preferably, such a PLL is a digital PLL comprising a LC oscillator, because such an oscillator is capable of generating frequencies with much lower phase noise than a ring oscillator, such that a better quality test signal is obtained. In fact, when using a ring oscillator, the quality of the generated signal is unlikely to be sufficient to achieve accurate test results.

This calibration signal generator, which is used in the functional mode of the IC, may be re-used in the test mode to inject a test signal into the receiver chain. Consequently, the amount of test-dedicated hardware can be reduced because no test-specific signal generator is required.

In an embodiment, the method further comprises the step of generating the test signal by multiplying the RF calibration signal with a signal from a phase-locked loop. This way, a two-tone test signal may be generated which can be used for determining receiver chain characteristics such as the IP2 and IP3 point, amongst others.

In a preferred embodiment, the method further comprises providing a loopback path between the transmitter chain output and the receiver chain input in said test mode; injecting a further test signal into the transmitter chain input following said evaluation; collecting a further response to the further test signal from the receiver chain output; and evaluating said further response.

The advantage of this embodiment over known test solutions in which such a loopback path is provided is that because the receiver chain has been tested previously, an improved test resolution is obtained because faulty behavior during loopback test can be attributed to the transmitter chain without requiring additional tests in contrast to the prior art loopback methods where such additional testing is required to localize the fault in either the receiver of transmitter chain.

Advantageously, the method further comprises attenuating the further test signal received from the transmitter chain output in said loopback path. Such attenuation prevents a power mismatch between a signal produced by a power amplifier at the end of the transmitter chain and a low noise amplifier at the front of the receiver chain.

According to a further aspect of the present invention, there is provided an integrated circuit comprising a digital signal processor; a radio-frequency (RF) transceiver, said transceiver comprising a receiver chain having an input for coupling the receiver chain to an antenna and an output coupled to the digital signal processor, and a transmitter chain having an input coupled to the digital signal processor and an output for coupling the transmitter chain to an antenna; and a RF calibration signal generator for generating a RF calibration signal, wherein the RF calibration signal generator is configurably coupled to the receiver chain input for injecting a test signal comprising the RF calibration signal generator into the receiver chain during a test mode of the integrated circuit.

Such an IC comprises a BIST arrangement which re-uses functional mode hardware components, thus reducing the area overhead of the BIST arrangement.

In an embodiment, the integrated circuit further comprises a multiplier having an input configurably coupled to the calibration signal generator, a further input configurably coupled to a local oscillator, and an output coupled to the receiver chain input. The multiplier ensures that a two-tone signal for testing the receiver chain can be generated.

Preferably, the transmitter chain output is configurably coupled to the receiver chain input for providing a loopback path from the transmitter chain to the receiver chain in said test mode such that the whole transceiver can be tested using the loopback path after the receiver chain has been tested. This has the advantage that errors detected during the loopback test can be attributed to the transmitter chain because the receiver chain is a known good chain.

The loopback path may comprises a programmable attenuator to ensure that .that the transmitter chain output signal strength is matched to the dynamic signal range of the receiver chain input, which may be located in a low-noise amplifier. The loopback path may further comprise a bypass for bypassing the programmable attenuator for test modes in which such signal strength matching is unnecessary.

The IC of the present invention may be integrated in an electronic device such as a mobile communication device, e.g. a mobile phone, a digital personal assistant, a Bluetooth-enabled personal computer and so on.

### BRIEF DESCRIPTION OF THE EMBODIMENTS

Embodiments of the invention are described in more detail and by way of non-limiting examples with reference to the accompanying drawings, wherein
FIG.1 schematically depicts an IC according to an embodiment of the present invention;
FIG.2 schematically depicts an aspect of an IC according to an embodiment of the present invention;
FIG.3 schematically depicts another aspect of an IC according to an embodiment of the present invention; and
FIG.4 schematically depicts test signals generated in accordance with an aspect of an embodiment of the method of present invention.

### DETAILED DESCRIPTION OF THE DRAWINGS

It should be understood that the Figures are merely schematic and are not drawn to scale. It should also be understood that the same reference numerals are used throughout the Figures to indicate the same or similar parts.

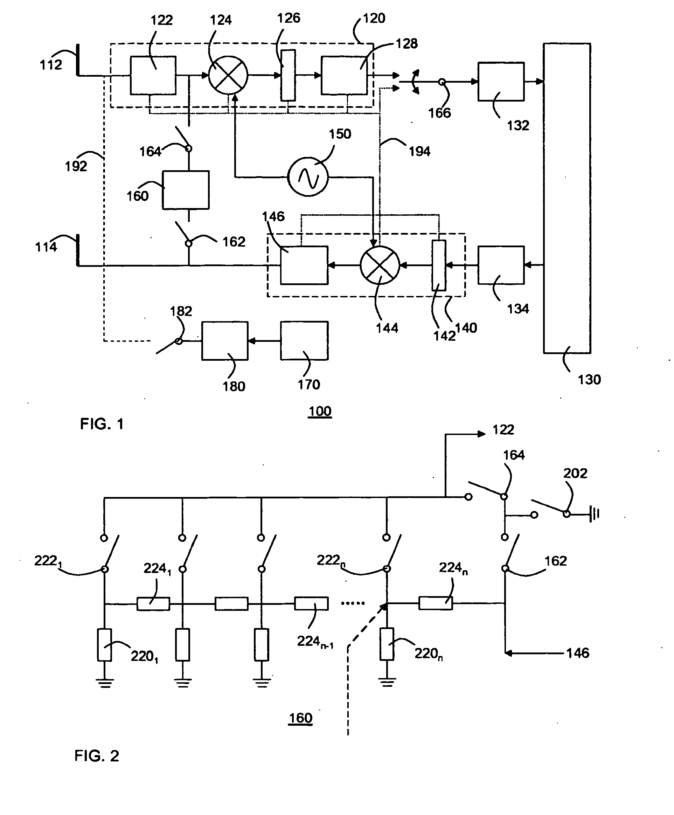

Fig.1 shows a part of an IC 100 in accordance with an embodiment of the present invention. The IC 100 comprises a receiver chain 120 coupled to an antenna 112 and a transmitter chain 140 coupled to an antenna 114. Antennae 112 and 114 may be implemented as a single antenna or as separate antennae. The receiver chain 120 is coupled to a digital signal processor (DSP) 130 via an analogue-to-digital converter (ADC) 132, whereas the transmitter chain 140 is coupled to the DSP 130 via a digital-to-analogue converter (DAC) 134. The receiver chain 120 and the transmitter chain 140 may be configured in any suitable way. By way of non-limiting example, Fig. 1 shows the receiver chain 120 to comprise a low-noise amplifier (LNA) 122, a frequency mixer 124, a baseband filter 126 and an automatic gain control (AGC) block 128, and the transmitter chain 140 to comprise a baseband filter 142, a frequency mixer 144 and a power amplifier 146. The frequency mixers 124 and 144 are arranged to receive a reference signal from a local oscillator 150.

It should be understood that the exact configurations and implementations of the receiver and transmitter chains 120, 140 are not essential to the present invention and that alternative configurations are envisaged without departing from the scope of the present invention.

The IC 100 typically further comprises a calibration signal generator 170, which preferably is a digital PLL comprising an LC oscillator, as previously explained. Such a calibration signal generator may be used in functional (normal) mode to compensate for design changes due to temperature variation, ageing and so on.

The calibration signal generator 170 is adapted to provide the IC 100 with a calibration signal in normal operation, e.g. a PLL generating a calibration signal in the GHz domain, as for instance is used in polar modulated transceivers such as Bluetooth transceivers. In accordance with the present invention, the calibration signal generator 170 is configurably coupled to the input of LNA 122 via a switch 182 and a bus 192. The switch 182 is enabled, i.e. switched to a conductive state, during a test mode of the IC 100 such that the calibration signal, or a derivate thereof as will be explained in more detail later, may be injected into the receiver chain 120 via the LNA 122. An attenuator 180 may be present between the calibration signal generator 170 and the receiver chain 120, for instance between the calibration signal generator 170 and the switch 182, to attenuate the calibration signal of the calibration signal generator 170 such that this signal lies within the dynamic range of the LNA 122. Preferably, the attenuator 180 is a programmable attenuator such test signals with variable attenuation may be generated, which enables gain and distortion measurement of the receiver chain 120.

In an embodiment, the bus 192 is a direct current (DC) input line. Such a line is a simple structure that can be realized with minimal area overhead, contrary to a bus suitable for propagating RF signals, which is more area-demanding because of shielding requirements to reduce coupling effects, which is generally not desirable in an IC design for this reason. A DC bus can only propagate small energy RF signals, but the present invention is, amongst others, based on the realization that a LNA 122 is capable of amplifying such small energy signals to a signal intensity that is sufficient to adequately test the receiver chain 120.

The analogue test response of the receiver chain 120 may be digitized by the ADC 132 after which the DSP 130 may be configured to analyze this test response, e.g. by comparing it with an expected test response such as the test response from a known good device, and calculating if the differences between the collected test response and the expected test response fall within acceptable tolerances. The DSP 130 may be configured to generate a pass/fail signal in response to this evaluation, which may be made available on an external pin (not shown) of the IC 100 to notify a person testing the IC 100 of the test result. Alternatively, the test response evaluation may be performed by an off-chip DSP. The receiver chain test may include the determination of RF parameters such as IP2, IP3, compression point as well as receiver gain I/Q imbalance and the cutoff frequency of the receiver chain 120.

During test, if it is determined that the receiver chain 120 is faulty, the IC 100 may be rejected. Otherwise, the IC 100 may be subjected to further tests, including a loopback test in which the whole transceiver is tested. To this end, the IC 100 further comprises a loopback path from the output of the transmitter chain 140 to the input of the receiver chain 120.

The loopback path may be connected to the input of the LNA 122 or, in an alternative embodiment, to the input of the frequency mixer 124. The latter embodiment has the advantage that the load impedance of the antenna is not affected by the loopback path, thus avoiding potential matching problems and a reduction in transmitted power efficiency. Also, the unintentional transmission of some of the loopback signal by the antenna is avoided this way. It is pointed out that the LNA 122 may be left out of the loop because the test signal exiting the transmitter chain is a strong RF signal that does not require further amplification, in contrast to the signal originating from the calibration signal generator 170 used to test the receiver chain 120.

In an embodiment, the loopback path comprises two test enable switches 162, 164 and a programmable attenuator 160 in between these test enable switches.

During loopback test, the test enable switches 162 and 164 are enabled, and the DSP 130 is configured to inject a further test signal into the transmitter chain 140 via DAC 134, and the collect a further test response to the further test signal of the transceiver from ADC 132. By comparing the further test response with an expected response, the DSP 130 can determine whether or not the transceiver chain operates within acceptable tolerances. If not, it is immediately evident that the transmitter chain 140 is faulty because the receiver chain 120 has already passed the previous test using a test signal from the calibration signal generator 170. For example, the loopback test may be used to determine the error vector magnitude (EVM) and the bit error ratio (BER) of the transceiver. Such tests are known to produce high fault coverage.

In an embodiment, the IC 100 further comprises a further DC signal bus 194 for DC-testing the various components of the transceiver. In case of the presence of the further DC signal bus 194, a selection switch 166 may be placed between the receiver chain 120 and the ADC 132 to select whether the receiver chain 120 and the further DC signal bus 194 is to be coupled to the ADC 132. Since such DC tests are well-known to the skilled person, they will not be explained in further detail for reasons of brevity only.

The presence of the further DC signal bus 194 further enables testing of the calibration signal generator 170 because the further DC signal bus 194 may be used to bypass the receiver chain 120. To this end, the calibration signal generator 170 may comprise design-for-testability (DfT) components (not shown) to switch the calibration signal generator 170 to such a test mode. This way, it can be ensured that the test signal used for testing the receiver chain 120, as previously explained, itself originates from a fault-free calibration signal generator 170 such that receiver chain test results are not obscured by an unreliable test signal.

Hence, the IC 100 as shown in Fig. 1 is equipped to be tested as follows:
1. Perform a DC bias test using the further DC signal bus 194 (and the DC line 192) to extend test coverage to blocks that do not directly influence RF parameters, such as bias blocks and other supporting circuitry;
2. Test the calibration signal generator 170 by switching this generator to a test mode and bypassing the receiver chain 120 using the further DC signal bus 194 ;
3. testing the receiver chain 120 by injecting a signal from the calibration signal generator 170 into the LNA 122; and
4. testing the transceiver by enabling the loopback path from the transmitter chain 140 to the receiver chain 120, generating a further test signal with the DSP 130 and injecting the further test signal into the transmitter chain 140.

This test sequence provides excellent test coverage and improved fault identification resolution compared to prior art solutions. It will be obvious to the skilled person that the DfT architecture of the IC 100 may be extended, e.g. by the inclusion of further loopback paths between intermediate components of the transmitter chain 140 and receiver chain 120 to further improve the fault coverage. Obviously, the above test sequence is particularly designed to test the analogue parts of the IC 100 in a built-in self test manner. The digital parts of the IC 100 such as the DSP 130 may be tested in an alternative fashion, such as by means of a digital ATE.

Fig. 2 shows an embodiment of a programmable attenuator, such as attenuator 160. The programmable attenuator in Fig. 2 is a non-limiting example of a programmable attenuator. It should be understood that such devices are known per se and any suitable programmable attenuator may be used.

The programmable attenuator 160 comprises n selectable resistor pair stages each comprising a first resistor 220 and a second resistor 224 and a selection switch 222. The selection switches 220₁₋ₙ may be configured in any suitable way, e.g. by means of a shift register for receiving configuration data from a test controller (not shown). The resistor 224ₙ has a resistance that is several orders higher than the resistors 220₁₋ₙ and/or the resistors 224₁₋₍ₙ₋₁₎ to ensure a high attenuation by stage n. This ensures that only enable switch 162 needs to be designed using a relatively thick gate oxide to be able to handle high currents. The subsequent attenuator stages, i.e. switches 222₁₋ₙ, are consequently exposed to a much lower input signal level such that normal switches may be used. The input impedance Zᵢₙ of the attenuator 160, i.e. the input receiving the output signal of the transmitter chain 140, is made high, so that the power loss in the attenuator is small.

This is an important design specification because if Zᵢₙ is not high enough, part of the power transmitted by the transmitter chain 140 is absorbed by the attenuation during normal operation. In normal operation, the further switch 202 may be enabled together with enable switch 164 such that the corresponding node of the receiver chain, e.g. the input of the frequency mixer 124 or the LNA 122, is connected to fixed potential, e.g. ground.

The gain of the attenuator and the RX path may be calibrated by injecting a signal from an accurate absolute output of the RF calibration generator 170 into the resistor 224ₙ, as indicated by the dashed line.

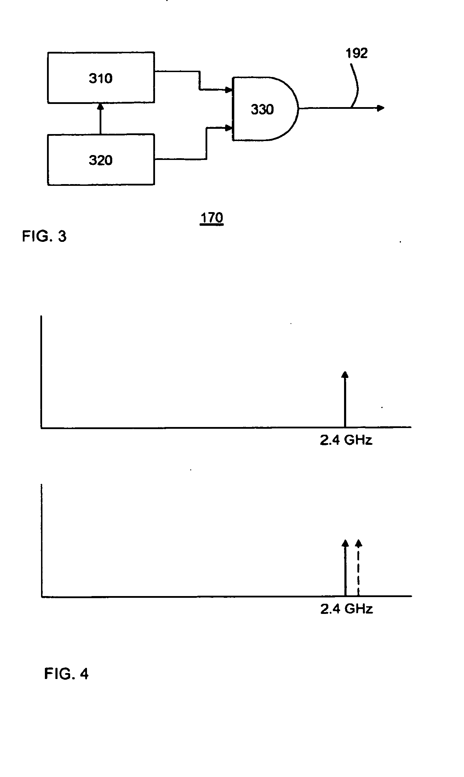

FIG. 3 shows an embodiment of a calibration signal generator 170 adapted to generate a two-tone signal. The output of single tone RF signal source 310 such as a PLL is combined with the output of the source 320 of a signal having a much lower frequency, e.g. a local oscillator oscillating at 50MHz. The combination may be achieved by a multiplier, which may be implemented as a logic gate such as an AND gate 330. The output of the calibration signal generator 170 is provided to the DC line 192. It should be appreciated that the calibration signal generator 170 may be amended to selectively generate one-tone and two-tone signals, e.g. by the provision of a configurable bypass from the RF signal source 310 to the DC line 192, thus circumventing the multiplier, or by the insertion of an enable switch in the signal path between the signal source 320 and the multiplier.

FIG. 4 shows a single-tone signal at 2.4 GHz from the RF signal source 310 and a dual-tone signal at 2.40 and 2.45 GHz respectively by the combination of the signals from the RF signal source 310 and the local oscillator 320. The receiver chain 120 may be tested with both single-tone as well as dual-tone test signals to test different characteristics of the receiver chain 120.

It should be noted that the above-mentioned embodiments illustrate rather than limit the invention, and that those skilled in the art will be able to design many alternative embodiments without departing from the scope of the appended claims. In the claims, any reference signs placed between parentheses shall not be construed as limiting the claim. The word "comprising" does not exclude the presence of elements or steps other than those listed in a claim. The word "a" or "an" preceding an element does not exclude the presence of a plurality of such elements. The invention can be implemented by means of hardware comprising several distinct elements. In the device claim enumerating several means, several of these means can be embodied by one and the same item of hardware.

## Claims

1. A method of testing an integrated circuit (100) comprising:
a radio-frequency (RF) transceiver, said transceiver comprising a receiver chain (120) having an input for coupling the receiver chain to an antenna (112) and an output coupled to a digital signal processor (130), and a transmitter chain (140) having an input coupled to the digital signal processor (130) and an output for coupling the transmitter chain (140) to an antenna (114); and
a RF calibration signal generator (170) for providing the integrated circuit with a RF calibration signal in an operational mode of the integrated circuit, the method being **characterized by** comprising:
connecting the RF calibration signal generator (170) to the receiver chain input in a test mode;
injecting a test signal comprising the RF calibration signal into the receiver chain input;
collecting a response to the test signal from the receiver chain output; and
evaluating said response.

2. The method of claim 1, wherein said evaluation step is performed using the digital signal processor (130).

3. The method of claim 1, wherein said evaluation step is performed using an off-chip digital signal processor.

4. The method of any of claims 1-3; further comprising the step of generating the test signal by multiplying the RF calibration signal with a signal from a further signal source (320).

5. The method of any of claims 1-4, further comprising:
providing a loopback path between the transmitter chain output and the receiver chain input in said test mode;
injecting a further test signal into the transmitter chain input following said evaluation;
collecting a further response to the further test signal from the receiver chain output; and
evaluating said further response.

6. The method of claim 5, further comprising attenuating the further test signal received from the transmitter chain output in said loopback path.

7. The method of any of claims 1-6, wherein the receiver chain (120) comprises a low-noise amplifier (122) comprising the receiver chain input.

8. An integrated circuit (100) comprising:
a digital signal processor (130);
a radio-frequency (RF) transceiver, said transceiver comprising a receiver chain (120) having an input for coupling the receiver chain (120) to an antenna (112) and an output coupled to the digital signal processor (130), and a transmitter chain (140) having an input coupled to the digital signal processor (130) and an output for coupling the transmitter chain (140) to an antenna (114); and
a RF calibration signal generator (170) for providing the integrated circuit with a RF calibration signal in an operational mode of the integrated circuit, **characterized in that** the RF calibration signal generator is configurably coupled to the receiver chain input for injecting a test signal comprising the RF calibration signal into the receiver chain (120) during a test mode of the integrated circuit (100).

9. The integrated circuit (100) of claim 8, wherein the digital signal processor (130) is arranged to evaluate a response to said test signal.

10. The integrated circuit (100) of claim 8 or 9, further comprising a multiplier (330) having an input configurably coupled to the calibration signal generator (310), a further input configurably coupled to a local oscillator (320), and an output coupled to the receiver chain input.

11. The integrated circuit (100) of any of claims 8-10, wherein the transmitter chain output is configurably coupled to the receiver chain input for providing a loopback path from the transmitter chain (140) to the receiver chain (120) in said test mode.

12. The integrated circuit (100) of claim 11, wherein said loopback path comprises a programmable attenuator (160).

13. The integrated circuit (100) of claim 12, wherein the loopback path further comprises a bypass for bypassing the programmable attenuator (160).

14. An electronic device comprising the integrated circuit (100) of any of claims 8-13.

## Patentansprüche

1. Verfahren zum Testen eines integrierten Schaltkreises (100) aufweisend:
einen Radiofrequenz (RF) Sende-Empfänger, wobei der Sende-Empfänger eine Empfängerkette (120), welche einen Eingang zum Koppeln der Empfängerkette an eine Antenne (112) und einen an einen digitalen Signalprozessor (130) gekoppelten Ausgang hat, und eine Senderkette (140) aufweist, welche einen den digitalen Signalprozessor (130) gekoppelten Eingang und einen Ausgang zum Koppeln der Senderkette (140) an eine Antenne (114) hat; und
einen RF Kalibrierungssignalgenerator (170) zum Versorgen des integrierten Schaltkreises mit einem RF Kalibrierungssignal in einem Betriebsmodus des integrierten Schaltkreises, wobei das Verfahren gekennzeichnet ist, dass es aufweist:
Verbinden des RF Kalibrierungssignalgenerators (170) mit dem Empfängerketten-Eingang in einem Testmodus;
Einspeisen eines Testsignals, welches das RF Kalibrierungssignal aufweist, in den Empfängerketten-Eingang;
Sammeln einer Antwort auf das Testsignal von dem Empfängerketten-Ausgang; und
Evaluieren der Antwort.

2. Verfahren gemäß Anspruch 1, wobei der Evaluierungsschritt unter Verwenden des digitalen Signalprozessors (130) ausgeführt wird.

3. Verfahren gemäß Anspruch 1, wobei der Evaluierungsschritt unter Verwenden eines Off-Chip digitalen Signalprozessors ausgeführt wird.

4. Verfahren gemäß irgendeinem der Ansprüche 1 bis 3, ferner aufweisend den Schritt des Generierens des Testsignals mittels Multiplizierens des RF Kalibrierungssignals mit einem Signal von einer weiteren Signalquelle (320).

5. Verfahren gemäß irgendeinem der Ansprüche 1 bis 4, ferner aufweisend:
Bereitstellen eines Loopback-Pfades zwischen dem Senderketten-Ausgang und dem Empfängerketten-Eingang in dem Testmodus;
Einspeisen eines weiteren Testsignals in den Senderketten-Eingang folgend der Evaluierung;
Sammeln einer weiteren Antwort auf das weitere Testsignal von dem Empfängerketten-Ausgang; und
Evaluieren der weiteren Antwort.

6. Verfahren gemäß Anspruch 5, ferner aufweisend Dämpfen des weiteren Testsignals, welches von dem Senderketten-Ausgang in dem Loopback-Pfad empfangen wurde.

7. Verfahren gemäß irgendeinem der Ansprüche 1 bis 6, wobei die Empfängerkette (120) einen rauscharmen Verstärker (122) aufweist, welcher den Empfängerketten-Eingang aufweist.

8. Integrierter Schaltkreis (100) aufweisend:
einen digitalen Signalprozessor (130);
einen Radiofrequenz (RF) Sende-Empfänger, wobei der Sende-Empfänger eine Empfängerkette (120), welche einen Eingang zum Koppeln der Empfängerkette (120) an eine Antenne (112) und einen an den digitalen Signalprozessor (130) gekoppelten Ausgang hat, und eine Senderkette (140) aufweist, welche einen an den digitalen Signalprozessor (130) gekoppelten Eingang und einen Ausgang zum Koppeln der Senderkette (140) an eine Antenne (114) hat; und
einen RF Kalibrierungssignalgenerator (170) zum Versorgen des integrierten Schaltkreises mit einem RF Kalibrierungssignal in einem Betriebsmodus des integrierten Schaltkreises,
**dadurch gekennzeichnet, dass** der RF Kalibrierungssignalgenerator konfigurierbar an den Empfängerketten-Eingang gekoppelt ist, um während eines Testmodus des integrierten Schaltkreises (100) ein Testsignal anzulegen, welches das RF Kalibrierungssignal aufweist in die Empfängerkette (120) einzuspeisen.

9. Integrierter Schaltkreis (100) gemäß Anspruch 8, wobei der digitale Signalprozessor (130) eingerichtet ist, zum Evaluieren einer Antwort auf das Testsignal.

10. Integrierter Schaltkreis (100) gemäß Anspruch 8 oder 9, ferner aufweisend einen Multiplizierer (330), welcher einen an den Kalibrierungssignalgenerator (310) konfigurierbar gekoppelten Eingang, einen weiteren an einen lokalen Oszillator (320) konfigurierbar gekoppelten Eingang, und einen an den Empfängerketten-Eingang gekoppelten Ausgang hat.

11. Integrierter Schaltkreis (100) gemäß irgendeinem der Ansprüche 8 bis 10, wobei der Senderketten-Ausgang konfigurierbar an den Empfängerketten-Eingang gekoppelt ist zum Versorgen eines Loopback-Pfades von der Senderkette (140) zu der Empfängerkette (120) in dem Testmodus.

12. Integrierter Schaltkreis (100) gemäß Anspruch 11, wobei der Loopback-Pfad einen programmierbaren Dämpfer (160) aufweist.

13. Integrierter Schaltkreis (100) gemäß Anspruch 12, wobei der Loopback-Pfad ferner einen Bypass zum Überbrücken des programmierbaren Dämpfers (160) aufweist.

14. Eine elektronische Vorrichtung aufweisend den integrierten Schaltkreis (100) gemäß irgendeinem der Ansprüche 8 bis 13.

## Revendications

1. Procédé de test d'un circuit intégré (100) comprenant :
un émetteur-récepteur radiofréquence (RF), ledit émetteur-récepteur comprenant une chaîne de réception (120) ayant une entrée pour raccorder la chaîne de réception à une antenne (112) et une sortie raccordée à un processeur de signal numérique (130), et une chaîne d'émission (140) ayant une entrée raccordée au processeur de signal numérique (130) et une sortie pour raccorder la chaîne d'émission (140) à une antenne (114) ; et
un générateur de signal d'étalonnage RF (170) pour fournir au circuit intégré un signal d'étalonnage RF dans un mode opérationnel du circuit intégré, le procédé étant **caractérisé en ce qu'**il comprend :
le raccordement du générateur de signal d'étalonnage RF (170) à l'entrée de la chaîne de réception dans un mode de test ;
l'injection d'un signal de test comprenant le signal d'étalonnage RF à l'entrée de la chaîne de réception ;
le recueil d'une réponse au signal de test à partir de la sortie de la chaîne de réception ; et
l'évaluation de ladite réponse.

2. Procédé selon la revendication 1, dans lequel ladite étape d'évaluation est réalisée à l'aide du processeur de signal numérique (130).

3. Procédé selon la revendication 1, dans lequel ladite étape d'évaluation est réalisée à l'aide d'un processeur de signal numérique externe.

4. Procédé selon l'une quelconque des revendications 1 à 3, comprenant en outre l'étape de génération du signal de test par multiplication du signal d'étalonnage RF par un signal provenant d'une autre source de signal (320).

5. Procédé selon l'une quelconque des revendications 1 à 4, comprenant en outre :
la mise en place d'un trajet de rebouclage entre la sortie de la chaîne d'émission et l'entrée de la chaîne de réception dans ledit mode de test ;
l'injection d'un autre signal de test à l'entrée de la chaîne d'émission à la suite de ladite évaluation ;
le recueil d'une autre réponse à l'autre signal de test à partir de la sortie de la chaîne de réception ; et
l'évaluation de ladite autre réponse.

6. Procédé selon la revendication 5, comprenant en outre l'atténuation de l'autre signal de test reçu de la sortie de la chaîne d'émission dans ledit trajet de rebouclage.

7. Procédé selon l'une quelconque des revendications 1 à 6, dans lequel la chaîne de réception (120) comporte un amplificateur faible bruit (122) comprenant l'entrée de la chaîne de réception.

8. Circuit intégré (100) comprenant :
un processeur de signal numérique (130) ;
un émetteur-récepteur radiofréquence (RF), ledit émetteur-récepteur comprenant une chaîne de réception (120) ayant une entrée pour raccorder la chaîne de réception (120) à une antenne (112) et une sortie raccordée au processeur de signal numérique (130), et une chaîne d'émission (140) ayant une entrée raccordée au processeur de signal numérique (130) et une sortie pour raccorder la chaîne d'émission (140) à une antenne (114) ; et
un générateur de signal d'étalonnage RF (170) pour fournir au circuit intégré un signal d'étalonnage RF dans un mode opérationnel du circuit intégré, **caractérisé en ce que** le générateur de signal d'étalonnage RF est raccordé de manière configurable à l'entrée de la chaîne de réception pour injecter un signal de test comprenant le signal d'étalonnage RF dans la chaîne de réception (120) au cours d'un mode de test du circuit intégré (100).

9. Circuit intégré (100) selon la revendication 8, dans lequel le processeur de signal numérique (130) est agencé de manière à évaluer une réponse audit signal de test.

10. Circuit intégré (100) selon la revendication 8 ou 9, comprenant en outre une multiplicateur (330) ayant une entrée raccordée de manière configurable au générateur de signal d'étalonnage (310), une autre entrée étant raccordée de manière configurable à un oscillateur local (320), et une sortie raccordée à l'entrée de la chaîne de réception.

11. Circuit intégré (100) selon l'une quelconque des revendications 8 à 10, dans lequel la sortie de la chaîne d'émission est raccordée de manière configurable à l'entrée de la chaîne de réception pour fournir un trajet de rebouclage de la chaîne d'émission (140) à la chaîne de réception (120) dans ledit mode de test.

12. Circuit intégré (100) selon la revendication 11, dans lequel ledit trajet de rebouclage comprend un atténuateur programmable (160).

13. Circuit intégré (100) selon la revendication 12, dans lequel le trajet de rebouclage comprend en outre une dérivation pour éviter l'atténuateur programmable (160).

14. Dispositif électronique comportant le circuit intégré (100) selon l'une quelconque des revendications 8 à 13.
